# EUROPÄISCHE PATENTSCHRIFT

(11) **EP 1 578 183 B1**
(45) Veröffentlichungstag und Bekanntmachung des Hinweises auf die Patenterteilung: **07.05.2008**
(21) Anmeldenummer: 05405205.5
(22) Anmeldetag: 21.02.2005
(51) Int. Cl.: H05K 7/14

(54) **Ein- und Aushebevorrichtung für Steckbaugruppen**
System for insertion and extraction
Dispositif pour insérer et extraire

(30) Priorität: 19.03.2004 EP 04405169; 29.07.2004 EP 04405483
(43) Veröffentlichungstag der Anmeldung: 21.09.2005
(73) Patentinhaber: ELMA Electronic AG, 8620 Wetzikon (CH)
(72) Erfinder: Oila, Kari, 8038 Zürich (CH); Heussi, Georg, 8645 Jona (CH)
(74) Vertreter: Sulzer Management AG

(56) Entgegenhaltungen:
- EP-A- 0 699 019
- DE-U1- 7 724 549
- US-A- 4 511 199
- US-A1- 2002 090 851
- ANONYMOUS: "Insertion and retention device for large cards" RESEARCH DISCLOSURE, KENNETH MASON PUBLICATIONS, WESTBOURNE, GB, Bd. 294, Nr. 55, Oktober 1988 (1988-10), XP007113022 ISSN: 0374-4353

## Beschreibung

Die Erfindung betrifft eine Ein- und Aushebevorrichtung zum Einstecken und Ausziehen einer Steckbaugruppe in beziehungsweise aus einem Baugruppenträger gemäss Oberbegriff von Anspruch 1, einen Ein- und Aushebegriff zur Verwendung in einer derartigen Ein- und Aushebevorrichtung, eine Steckbaugruppe mit einer derartigen Ein- und Aushebevorrichtung und einen Baugruppenträger mit einer derartigen Steckbaugruppe.

In Baugruppenträger einführbare Steckbaugruppen weisen auf der Rückseite Mehrfachsteckverbindungen auf, deren Einsteck- und Ausziehkräfte beim Einstecken beziehungsweise Ausziehen der Steckbaugruppe überwunden werden müssen. Steckbaugruppen sind deshalb üblicherweise frontseitig mit einem unteren und/oder oberen Ein- und Aushebegriff versehen, um das Einstecken und Ausziehen zu erleichtern. Die Ein- und Aushebegriffe sind drehbar angeordnet und derart an einem frontseitigen Profil des Baugruppenträgers abgestützt, dass die Ein- und Aushebegriffe beim Einstecken und Ausziehen als Hebel wirken. Zum Einsetzen einer Steckbaugruppe müssen die Ein- und Aushebegriff voll ausgeschwenkt sein, da sie sonst das Einsetzen der Steckbaugruppe in den Baugruppenträger behindern oder gänzlich verunmöglichen. Ohne entsprechende Vorkehrungen kann die Stellung der Ein- und Aushebegriff bei einer direkten Berührung oder bei einer stärkeren Bewegung der Steckbaugruppe unbeabsichtigt ändern. Insbesondere der obere Ein- und Aushebegriff neigt dazu, auf Grund der Schwerkraft nach unten zu kippen, sodass er beim Einsetzen der Steckbaugruppe festgehalten werden muss. Zur Zeit gibt es Bestrebungen, schmal geformte, längliche Ein- und Aushebegriffe auf den Markt zu bringen, die preisgünstig hergestellt werden können. Bei derartigen Ein- und Aushebegriffen stellt sich das Problem des unbeabsichtigten Einschwenkens in besonderem Masse.

Die aus dem Stand der Technik bekannten Ein- und Aushebegriffe sind meist mit einer Haltevorrichtung versehen, um den Ein- und Aushebegriffe in der eingeschwenkten Stellung zu halten und/oder zu verriegeln und ein unbeabsichtigtes Ausschwenken des Ein- und Aushebegriffs zu verhindern. Bei vollständig eingesetzter Steckbaugruppe befindet sich der Ein- und Aushebegriff in eingeschwenkter Stellung, so dass die Haltevorrichtung meist auch dazu dient, die Steckbaugruppe im eingesetzten Zustand zu sichern.

Aus Dokument DE 203 11 072 U1 ist eine Steckbaugruppe bekannt, in welcher an einem Hebelziehgriff ein Sperrhebel angelenkt ist, der den Hebelziehgriff in der ausgeschwenkten Stellung arretiert und gegen unbeabsichtigtes Verschwenken sperrt. Weiter umfasst der Sperrhebel eine Rastklinke, um den Hebelziehgriff in der eingeschwenkten Stellung zu fixieren. Die in DE 203 11 072 U1 beschriebene Konstruktion mit einem separaten Sperrhebel ist relativ aufwendig. Auch kann der Hebelziehgriff nur eingeschwenkt werden, indem gleichzeitig der Sperrhebel betätigt wird, was die Bedienung kompliziert.

Aufgabe der Erfindung ist es, eine Ein- und Aushebevorrichtung zum Einstecken und Ausziehen einer Steckbaugruppe in beziehungsweise aus einem Baugruppenträger zur Verfügung zu stellen, die sowohl gegen unbeabsichtigtes Einschwenken als auch gegen unbeabsichtigtes Ausschwenken geschützt ist, eine einfache Bedienung aufweist und die verglichen mit Ein- und Aushebevorrichtungen aus dem Stand der Technik wirtschaftlich hergestellt werden kann. Eine weitere Aufgabe der Erfindung besteht darin, einen Ein- und Aushebegriff für eine derartige Ein- und Aushebevorrichtung, eine Steckbaugruppe mit einer derartigen Ein- und Aushebevorrichtung und einen Baugruppenträger mit einer derartigen Steckbaugruppe zur Verfügung zu stellen.

Diese Aufgabe wird erfindungsgemäss durch die in Anspruch 1 definierte Ein-und Aushebevorrichtung gelöst sowie durch den in Anspruch 8 definierten Ein- und Aushebegriff, die in Anspruch 13 definierte Steckbaugruppe und den in Anspruch 14 definierten Baugruppenträger.

Die erfindungsgemässe Ein- und Aushebevorrichtung zum Einstecken und Ausziehen einer Steckbaugruppe in beziehungsweise aus einem Baugruppenträger umfasst einen Ein- und Aushebegriff und mindestens ein Führungselement, um welches der Ein- und Aushebegriff drehbar ist, vorzugsweise derart, dass durch das Führungselement die Richtung der Drehachse konstant gehalten wird. Zusätzlich ist der Ein- und Aushebegriff in einer Richtung, vorzugsweise in einer Richtung senkrecht zur Richtung der Drehachse verschiebbar.

In einer bevorzugten Ausführungsform ist der Ein- und Aushebegriff in seiner Längsrichtung verschiebbar, vorzugsweise verschiebbar geführt. Vorzugsweise ist das Führungselement als Passschulterschraube mit Schulter oder als Schraube mit Hülse ausgebildet.

In einer weiteren bevorzugten Ausführungsform umfasst die Ein- und Aushebevorrichtung zusätzlich eine Haltevorrichtung mit mindestens einem Halteelement, um den Ein- und Aushebegriff in ausgeschwenktem Zustand in einer zum Einstecken der Steckbaugruppe geeigneten Stellung zu halten und/oder um den Ein- und Aushebegriff in eingeschwenktem Zustand in einer eingeklinkten Stellung zu halten. Vorzugsweise ist das Halteelement als Feder ausgebildet, die derart mit dem Ein- und Aushebegriff wirkverbunden ist, dass die Feder in Drehrichtung und/oder in der Richtung der Verschiebung wirksam ist. Vorteilhaft ist eine Ausbildung des Halteelements als Schwenkfeder.

In einer bevorzugten Ausführungsvariante ist das Halteelement im Bereich des Führungselements, vorzugsweise am oder auf dem Führungselement, angeordnet.

In einer weiteren bevorzugten Ausführungsvariante ist ein Schaltelement für eine Aktiv-Passiv-Schaltung der Steckbaugruppe vorgesehen, welches mittels des Ein- und Aushebegriffs, insbesondere mittels eines am Ein- und Aushebegriff ausgebildeten Vorsprungs betätigbar ist.

Weiter umfasst die Erfindung einen Ein- und Aushebegriff zur Verwendung in einer Ein- und Aushebevorrichtung nach oben stehender Beschreibung, in welchem Ein- und Aushebegriff eine Führungsstruktur, insbesondere Führungsöffnung derart ausgebildet ist, dass der Ein- und Aushebegriff sowohl um ein Führungselement drehbar als auch an diesem verschiebbar ist, vorzugsweise indem das Führungselement in die Führungsöffnung eingreift. Vorzugsweise ist die Führungsstruktur länglich geformt und beispielsweise als Langloch ausgebildet.

In einer bevorzugten Ausführungsform ist der Ein- und Aushebegriff einteilig ausgebildet.

In einer weiteren bevorzugten Ausführungsform ist der Ein- und Aushebegriff in eingeschwenktem Zustand durch Verschiebung, vorzugsweise durch Verschiebung in seiner Längsrichtung und/oder in Richtung senkrecht zur Richtung der Drehachse und/oder parallel zu einer Frontplatte der Steckbaugruppe in der Frontplatte einklinkbar. Vorzugsweise ist am Ein- und Aushebegriff ein Vorsprung ausgebildet, welcher durch eine Öffnung in der Frontplatte der Steckbaugruppe einführbar ist und welcher derart geformt ist, dass er in eingeschwenktem Zustand des Ein- und Aushebegriffs durch Verschieben, insbesondere durch Verschieben in der Längsrichtung des Ein-und Aushebegriffs, beispielsweise in Richtung senkrecht zur Richtung der Drehachse und/oder parallel zur Frontplatte, in derselben einklinkbar ist.

Weiter umfasst die Erfindung eine Steckbaugruppe mit mindestens einer Ein-und Aushebevorrichtung nach oben stehender Beschreibung und/oder mit einem Ein- und Aushebegriff nach oben stehender Beschreibung sowie einen Baugruppenträger mit mindestens einer derartigen Steckbaugruppe.

Die erfindungsgemässe Ein- und Aushebevorrichtung hat den Vorteil, dass der Ein- und Aushebegriff sowohl in ausgeschwenkter als auch in eingeschwenkter Stellung durch die Haltevorrichtung gehalten wird, so dass ein unbeabsichtigtes Einschwenken beziehungsweise Ausschwenken des Ein- und Aushebegriffs vermieden wird. Falls als Halteelement ein entsprechendes Federelement verwendet wird, bewirkt dessen Federkraft, dass der Ein- und Aushebegriff in die ausgeschwenkte Stellung geschwenkt wird, sobald die Steckbaugruppe aus dem Baugruppenträger herausgezogen wird. Das Halteelement wird mit Vorteil als Federelement mit Doppelfunktion ausgeführt, das den Ein- und Aushebegriff in ausgeschwenktem Zustand hält, wenn die Steckbaugruppe herausgezogen ist, und in eingeklinkten Zustand, wenn die Steckbaugruppe eingesetzt ist. Die Anordnung des Halteelements im Bereich des Führungselements ermöglicht zusätzlich eine einfache und platzsparende Auslegung des Halteelements. Dadurch, dass der Ein- und Aushebegriff in eingeschwenktem Zustand direkt an der Frontplatte eingeklinkt werden kann, erübrigt sich ein gesondertes Verriegelungselement, so dass der Ein- und Aushebegriff einteilig ausgeführt werden kann. Durch die geringe Anzahl von Bestandteilen der erfindungsgemässen Ein- und Aushebevorrichtung können die Herstellungskosten gegenüber herkömmlichen Ein- und Aushebevorrichtungen gesenkt werden. Ein weiterer Vorteil der erfindungsgemässen Ein- und Aushebevorrichtung ist die einfache Bedienung derselben. Zum Einschwenken des Ein- und Aushebegriffs muss lediglich der Widerstand des Halteelements überwunden werden.

Weitere vorteilhafte Ausführungsformen gehen aus den abhängigen Ansprüchen und der Zeichnung hervor.

Im Folgenden wird die Erfindung an Hand des Ausführungsbeispiels und an Hand der Zeichnung näher erläutert. Es zeigen:
- Fig. 1: eine Schrägansicht eines Ausschnitts aus einer Steckbaugruppe mit einem Ausführungsbeispiel einer Ein- und Aushebevorrichtung gemäss vorliegender Erfindung,
- Fig. 2: eine Schrägansicht einer Ausführungsvariante eines Frontprofils zu der in Fig. 1 gezeigten Steckbaugruppe,
- Fig. 3: eine Schrägansicht einer Ausführungsvariante einer Passschulterschraube zu dem in Fig. 1 gezeigten Ausführungsbeispiel,
- Fig. 4: eine Schrägansicht einer Ausführungsvariante einer Schenkelfeder zu dem in Fig. 1 gezeigten Ausführungsbeispiel,
- Fig. 5 a -c: einen Längsschnitt durch einen Ausschnitt einer Steckbaugruppe mit einer Ein- und Aushebevorrichtung gemäss Ausführungsbeispiel und mit dem Ein- und Aushebegriff in drei verschiedenen Positionen,
- Fig. 6a-c: einen Längsschnitt durch den in den Fig. 5 a - c gezeigten Ausschnitt einer Steckbaugruppe mit dem Ein- und Aushebegriff in drei verschiedenen Positionen und mit einem Schaltelement zur Aktiv-Passiv-Schaltung der Steckbaugruppe, und
- Fig. 7 a, b: den Ausschnitt aus Fig. 6 c mit zwei Anordnungsvarianten des Schaltelements.

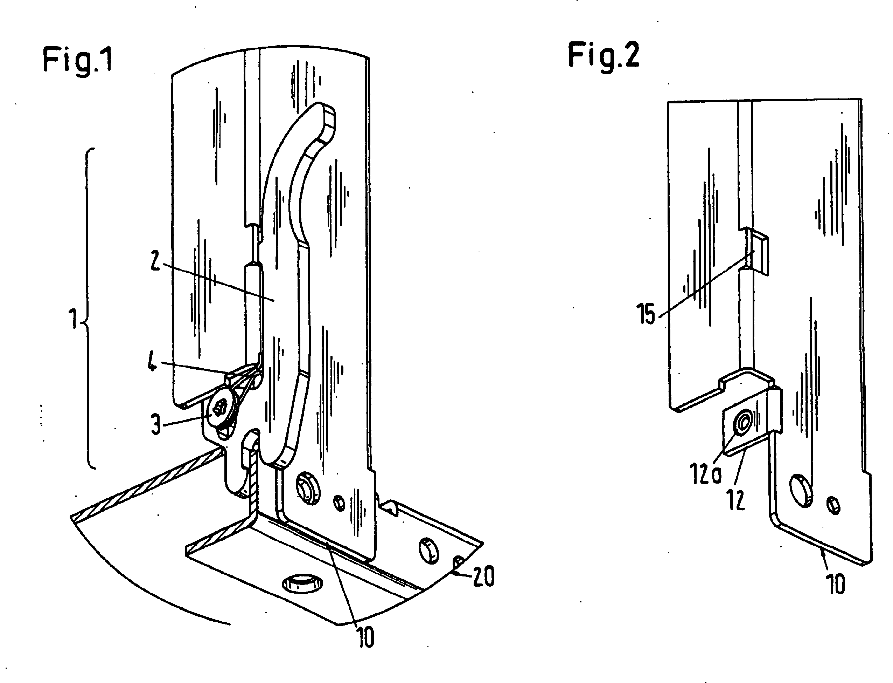

Fig. 1 zeigt eine Schrägansicht eines Ausschnitts aus einer Steckbaugruppe mit einem Ausführungsbeispiel einer Ein- und Aushebevorrichtung 1 gemäss vorliegender Erfindung. Die Ein- und Aushebevorrichtung umfasst einen Ein-und Aushebegriff 2 und ein Führungselement 3, um welches der Ein- und Aushebegriff drehbar ist und an welchem derselbe verschiebbar geführt ist, beispielsweise in einer Richtung senkrecht zur Drehachse. Vorteilhafterweise ist der Ein- und Aushebegriff 2 in seiner Längsrichtung verschiebbar geführt. Das Führungselement 3 kann beispielsweise als Passschulterschraube oder als Schraube mit Hülse ausgebildet sein. Weiter umfasst die Ein- und Aushebevorrichtung 1 eine Haltevorrichtung mit mindestens einem Halteelement 4, das in dem in Fig. 1 gezeigten Ausführungsbeispiel als Schenkelfeder ausgebildet ist, die im Bereich des Führungselements 3 angeordnet ist und dieses beispielsweise umschliesst.

Weiter ist in dem in Fig. 1 gezeigten Ausschnitt ein Frontprofil 10 einer Steckbaugruppe dargestellt sowie ein Frontprofil 20 eines Baugruppenträgers, in den die Steckbaugruppe eingesetzt ist. Die Ein- und Aushebevorrichtung 1 ist im unteren Bereich des Frontprofils 10 der Steckbaugruppe an dieser befestigt, derart, dass der zugehörige Ein- und Aushebegriff 2 nach vorne ausgeschwenkt werden kann und in eingeschwenkter Stellung desselben das Frontprofil 20 des Baugruppenträgers in eine Einbuchtung des Ein- und Aushebegriffs eingreift. Beim Ausschwenken des Ein- und Aushebegriffs 2 stützt sich dieser am Frontprofil 20 des Baugruppenträgers ab, wodurch die Steckbaugruppe aus dem Baugruppenträger gezogen wird. Umgekehrt kann beim Einsetzen der Steckbaugruppe durch Einschwenken des Ein- und Aushebegriffs 2 die Steckbaugruppe in entsprechender Weise in den Baugruppenträger eingeschoben werden.

In einer vorteilhaften Ausführungsvariante umfasst die Ein- und Aushebevorrichtung 1 zusätzlich eine Haltevorrichtung mit mindestens einem Halteelement 4, um den Ein- und Aushebegriff 2 bei eingesetzter Steckbaugruppe in einer eingeschwenkten Stellung zu halten, insbesondere in einer eingeklinkten Stellung. In einer weiteren vorteilhaften Ausführungsvariante umfasst die Ein- und Aushebevorrichtung 1 eine Haltevorrichtung mit mindestens einem Halteelement 4, um den Ein- und Aushebegriff 2 in einer ausgeschwenkten Stellung zu halten, um das Einsetzen der Steckbaugruppe zu erleichtern. Mit Vorteil wird das Halteelement, wie in Fig. 1 gezeigt als Federelement mit Doppelfunktion ausgeführt, das den Ein- und Aushebegriff in ausgeschwenktem Zustand hält, wenn die Steckbaugruppe herausgezogen ist und in eingeklinkten Zustand, wenn die Steckbaugruppe eingesetzt ist.

Fig. 2 zeigt eine Schrägansicht einer bevorzugten Ausführungsvariante eines Frontprofils zu der in Fig. 1 gezeigten Steckbaugruppe. Das Frontprofil 10 umfasst in dieser Ausführungsvariante einen Befestigungsteil 12, der mit dem Frontprofil verbunden ist und zur Befestigung eines Führungselements, beispielsweise einer Passschulterschraube der oben beschriebenen Ein- und Aushebevorrichtung dient. Das Befestigungsteil 12 kann beispielsweise als eingeklinkte Lasche des Frontprofils 10 ausgebildet sein. Vorteilhafterweise weist das Befestigungsteil eine Öffnung 12a auf, z.B. eine Öffnung mit Kragen oder eine eingepresste Buchse mit einem Gewindeteil, in die das Führungselement der oben beschriebenen Ein- und Aushebevorrichtung eingesetzt, eingepresst oder eingeschraubt werden kann. Vorteilhafterweise ist das Frontprofil mit einer Öffnung 15 versehen, um einen am Ein- und Aushebegriff der oben beschriebenen Ein- und Aushebevorrichtung ausgebildeten Vorsprung aufzunehmen.

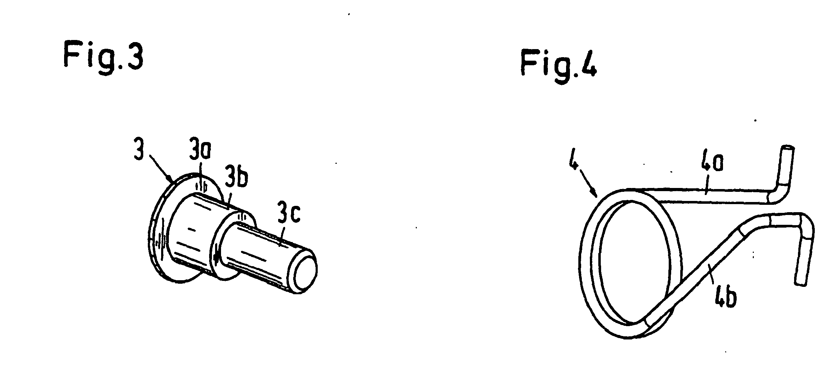

Fig. 3 zeigt eine Ausführungsvariante eines Führungselements zu dem in Fig. 1 gezeigten Ausführungsbeispiel. Das Führungselement ist in dieser Ausführungsvariante als Passschulterschraube ausgebildet, die einen Schraubenkopf 3a, eine Schulter 3b und einen Teil 3c mit Gewinde umfasst, welche zweckmässigerweise koaxial aneinandergereiht angeordnet sind, wobei der Schraubenkopf den grössten Durchmesser, die Schulter einen mittleren und der Gewindeteil den kleinsten Durchmesser aufweisen. Mit Vorteil ist die Schulter zur Aufnahme des Halteelements ausgebildet, sodass auf der Schulter neben dem Ein- und Aushebegriff ein Halteelement, wie z.B. eine Feder angeordnet werden kann. Vorteilhafterweise ist das Führungselement beziehungsweise die Passschulterschraube derart ausgestaltet, dass mittels derselben eine Leiterplatte der Steckbaugruppe am Befestigungsteil befestigt werden kann, beispielsweise indem die Leiterplatte mittels der Schulter 3b an das Befestigungsteil angedrückt wird. In einer bevorzugten Ausführungsvariante ist die Windung einer Schenkelfeder und/oder der Ein- und Aushebegriff auf der Schulter angeordnet, und die Breite der Schulter ist derart dimensioniert, dass der Ein- und Aushebegriff mittels der Schraubenfeder ausgeschwenkt werden kann. An Stelle der Passschulterschraube kann als Führungselement z.B. auch eine Schraube mit Hülse verwendet werden.

Fig. 4 zeigt eine Ausführungsvariante eines Halteelements zu dem in Fig. 1 gezeigten Ausführungsbeispiel. Das Halteelement 4 ist als Schenkelfeder ausgebildet, welche vorzugsweise mindestens eine Windung einer Schraubenfeder sowie zwei Schenkel 4a, 4b umfasst, die an Ihrem äusseren Ende abgebogen beziehungsweise abgekröpft sein können. Im Ausführungsbeispiel von Fig. 1 ist das abgekröpfte Ende des einen Schenkels am Hebel 2 verankert, während das abgebogene Ende des andern Schenkels am Frontprofil 10 der Steckbaugruppe abgestützt ist.

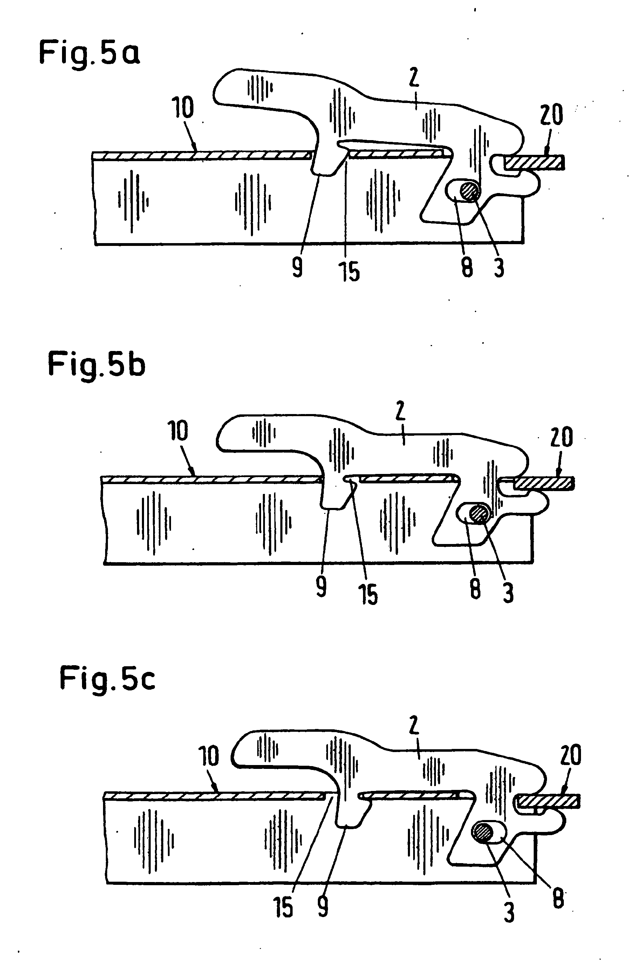

In den Figuren 5a-c ist ein Längsschnitt durch einen Ausschnitt einer Steckbaugruppe mit einer Ein- und Aushebevorrichtung gemäss Ausführungsbeispiel dargestellt. Die Figuren zeigen den Ein- und Aushebegriff 2 in drei verschiedenen Positionen während dem Einschwenken und Einklinken. Am Ein- und Aushebegriff 2 ist in der gezeigten Ausführungsform ein Vorsprung 9 ausgebildet, der beim Einschwenken des Ein- und Aushebegriffs durch eine Öffnung 15 der Frontplatte 10 der Steckbaugruppe einführbar ist. Weiter ist am Ein- und Aushebegriff 2 in der gezeigten Ausführungsform eine länglich geformte Führungsöffnung 8, beispielsweise ein Langloch vorgesehen, welche mit einem in die Führungsöffnung eingreifenden Führungselement 3 der Ein- und Aushebevorrichtung zusammenwirkt. Die Längsrichtung der Führungsöffnung verläuft vorteilhafterweise im Wesentlichen parallel zur Längsrichtung des Ein-und Aushebegriffs 2, sodass der Ein- und Aushebegriff 2 um das Führungselement 3 drehbar sowie am Führungselement in der Längsrichtung geführt ist. Ein Endbereich des Ein- und Aushebegriffs 2 ist derart ausgebildet, dass der Ein- und Aushebegriff beim Ein- und Ausschwenken an einem Profil 20 des Baugruppenträgers abgestützt ist, um das Einsetzen und Ausziehen der Steckbaugruppe zu erleichtern.

Fig. 5a zeigt den Ein- und Aushebegriff 2 beim Einschwenken. Ein Teil des Vorsprungs 9 des Ein- und Aushebegriffs ist bereits in die Öffnung 15 der Frontplatte 10 eingeführt. Dabei ist der Ein- und Aushebegriff 2 in Fig. 5a in Längsrichtung in eine Einführungsposition verschoben, was beispielsweise mittels einer entsprechenden Abschrägung am Vorsprung 9 erreicht werden kann. Vorteilhafterweise wirkt die im Bild nicht gezeigte Haltevorrichtung sowohl dem Einschwenken des Ein- und Aushebegriffs als auch dessen Verschiebung in Längsrichtung in die Einführungsposition entgegen.

Fig. 5b zeigt den Ein- und Aushebegriff 2 nach dem Einschwenken. Der Vorsprung 9 des Ein- und Aushebegriffs ist vollständig in die Öffnung 15 der Frontplatte 10 eingeführt, wobei der Ein- und Aushebegriff 2 in Fig. 5b in der Einführungsposition gezeigt ist. Vorteilhafterweise wirkt die im Bild nicht gezeigte Haltevorrichtung derart, dass der Ein- und Aushebegriff 2 beim Loslassen in Längsrichtung von der Einführungsposition in eine in Fig. 5c gezeigte Einklinkposition verschoben wird. Der Ein- und Aushebegriff braucht dann lediglich vollständig eingeschwenkt zu werden, worauf der Ein- und Aushebegriff durch die Haltevorrichtung selbsttätig eingeklinkt wird. Der Vorsprung 9 kann beispielsweise mit einer Einklinkkontur versehen sein, die im Frontprofil 10 der Steckbaugruppe einklinkbar ist. In der eingeklinkten Position ist der Ein- und Aushebegriff 2 gegen unbeabsichtigtes Ausschwenken geschützt und die Steckbaugruppe gegen Herausziehen und/oder -gleiten gesichert.

Zum Ausschwenken des Ein- und Aushebegriffs 2 wird dieser zunächst in Längsrichtung in die Einführungsposition verschoben und anschliessend ausgeschwenkt. Vorteilhafterweise erfolgt die Verschiebung in Einführungsposition gegen den Widerstand der Haltevorrichtung, während das anschliessende Ausschwenken von der Haltevorrichtung unterstützt werden kann. In einer weiteren vorteilhaften Ausführungsform wird der Ein-und Aushebegriff durch die Haltevorrichtung in der ausgeschwenkten Stellung gehalten.

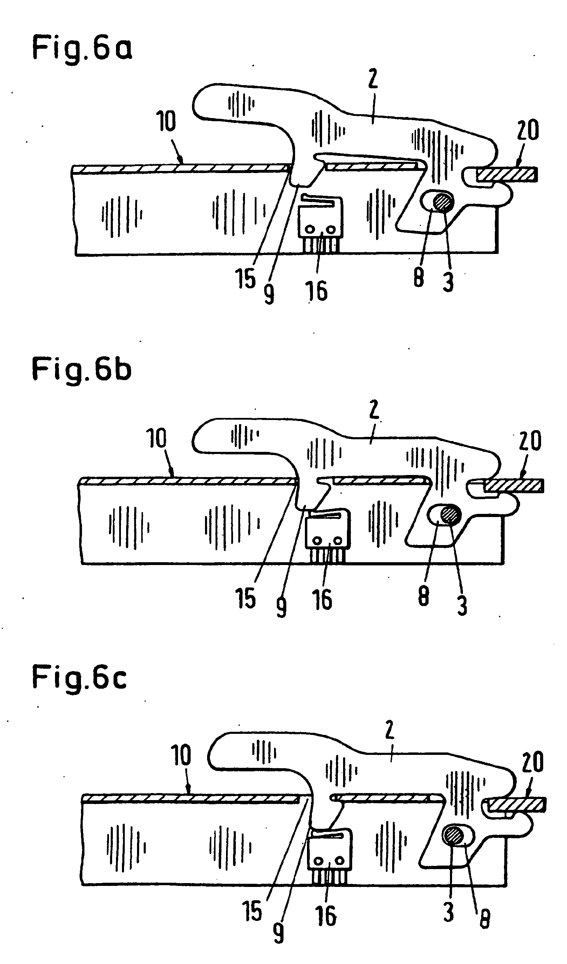

Die Figuren 6a-c zeigen einen Längsschnitt durch den in den Figuren 5a-c dargestellten Ausschnitt einer Steckbaugruppe mit einem zusätzlichen Schaltelement 16 zur Aktiv-Passiv-Schaltung der Steckbaugruppe. Das Schaltelement ist so angeordnet, dass der Vorsprung 9 des Ein- und Aushebegriffs 2 das Schaltelement 16 betätigt, sobald der Ein- und Aushebegriff die eingeschwenkte Endstellung erreicht und der Vorsprung in die Öffnung 15 der Frontplatte 10 der Steckbaugruppe eingeführt ist. Der Schaltzustand ist in der gezeigten Ausführungsform unabhängig von der Längsverschiebung des Ein- und Aushebegriffs, d.h. der Schaltzustand ist sowohl in der Einführungsposition (siehe Fig. 6b) als auch in der Einklinkposition (siehe Fig. 6c) derselbe. Das Schaltelement 16 kann beispielsweise als Mikroschalter ausgeführt sein und z.B. dazu verwendet werden, eine Funktion in der Steckbaugruppe zu aktivieren, z.B. ein Anzeigeelement, welches anzeigt, dass die Steckbaugruppe vollständig eingesteckt ist.

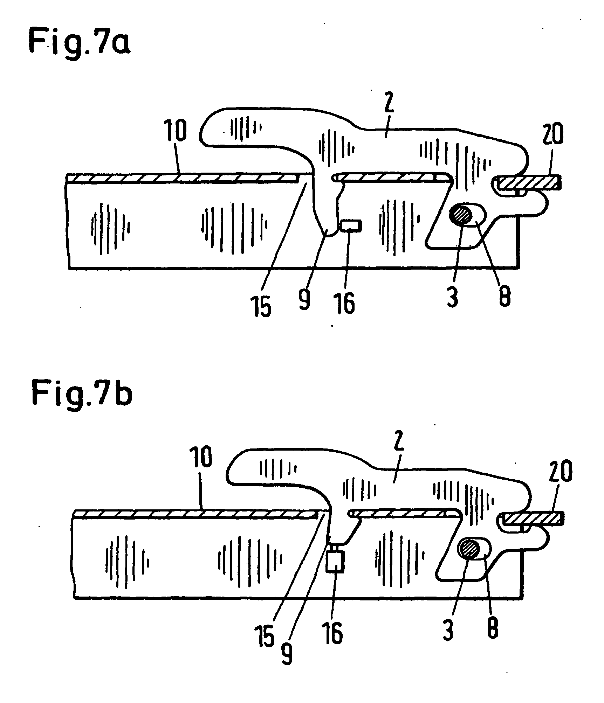

Die Figuren 7 a und b zeigen zwei Ausführungsvarianten des Schaltelements 16 zu dem in Fig. 6c gezeigten Ausschnitt. Das Schaltelement in Fig. 7a ist so angeordnet, dass dieses nur in der Einklinkposition des Ein- und Aushebegriffs 2 betätigt ist, d.h. die entsprechende Funktion beziehungsweise die entsprechenden Funktionen sind nur aktiviert, wenn der Ein- und Aushebegriff eingeklinkt ist. Fig. 7b zeigt eine alternative Ausführungsform des Schaltelements 16, bei welcher der Schaltzustand wie in der in den Figuren 6a-c gezeigten Ausführungsform unabhängig von der Längsverschiebung des Ein- und Aushebegriffs ist, d.h. die entsprechende Funktion beziehungsweise Funktionen sind aktiviert, sobald der Ein- und Aushebegriff die eingeschwenkte Endstellung erreicht hat.

Die Auslegung der Ein- und Aushebevorrichtung mit einem Ein- und Aushebegriff, der sowohl um ein Führungselement drehbar als auch in einer Richtung verschiebbar ist, ermöglicht einen einfachen und kostengünstigen Aufbau mit wenigen Bauteilen. Das Halteelement wird mit Vorteil im Bereich des Führungselements angeordnet und als Federelement mit Doppelfunktion ausgeführt, das den Ein- und Aushebegriff in ausgeschwenktem Zustand hält, wenn die Steckbaugruppe herausgezogen ist, und in eingeklinkten Zustand, wenn die Steckbaugruppe eingesetzt ist. Der Umstand, dass das Führungselement gleichzeitig mehrere Funktionen erfüllen kann, z.B. als Lager- und Führungsteil für den Ein- und Aushebegriff, als Befestigungselement für eine Leiterplatte oder als Befestigungsteil für die Haltevorrichtung, wirkt ebenfalls Kosten senkend. Ein weiterer Vorteil der erfindungsgemässen Ein- und Aushebevorrichtung ist die einfache Bedienung derselben, indem zum Einschwenken des Ein- und Aushebegriffs lediglich der Widerstand der Haltevorrichtung überwunden werden muss und der Ein- und Aushebegriff in der eingeschwenkten Stellung selbsttätig einklinkt. Zum Ausschwenken muss der Ein- und Aushebegriffs lediglich ausgeklinkt werden.

## Patentansprüche

1. Ein- und Aushebevorrichtung zum Einstecken und Ausziehen einer Steckbaugruppe in beziehungsweise aus einem Baugruppenträger, welche Ein- und Aushebevorrichtung (1) einen Ein- und Aushebegriff (2) umfasst und mindestens ein Führungselement (3), um welches der Ein- und Aushebegriff drehbar ist, **dadurch gekennzeichnet, dass** der Ein- und Aushebegriff (2) zusätzlich in seiner Längsrichtung verschiebbar geführt ist, und dass der Ein- und Aushebegriff (2) in eingeschwenktem Zustand durch Verschiebung, nämlich durch Verschiebung in seiner Längsrichtung in einer Frontplatte (10) der Steckbaugruppe einklinkbar ist.

2. Ein- und Aushebevorrichtung nach Anspruch 1, wobei das Führungselement (3) als Passschulterschraube mit Schulter (3b) oder als Schraube mit Hülse ausgebildet ist.

3. Ein- und Aushebevorrichtung nach einem der Ansprüche 1 oder 2 umfassend zusätzlich eine Haltevorrichtung mit mindestens einem Halteelement (4), um den Ein- und Aushebegriff (2) in einer zum Einstecken der Steckbaugruppe geeigneten Stellung zu halten und/oder um den Ein- und Aushebegriff (2) in eingeschwenktem Zustand in einer eingeklinkten Stellung zu halten.

4. Ein- und Aushebevorrichtung nach Anspruch 3, wobei das Halteelement (4) als Feder, insbesondere als Schenkelfeder ausgebildet ist, welche Feder derart mit dem Ein- und Aushebegriff (2) wirkverbunden ist, dass die Feder in Drehrichtung und/oder in der Richtung der Verschiebung wirksam ist.

5. Ein- und Aushebevorrichtung nach einem der vorangehenden Ansprüche, wobei das Halteelement (4) im Bereich des Führungselements (3), insbesondere am oder auf dem Führungselement, angeordnet ist.

6. Ein- und Aushebevorrichtung nach einem der vorangehenden Ansprüche, wobei ein Schaltelement (16) für eine. Aktiv-Passiv-Schaltung der Steckbaugruppe vorgesehen ist, welches Schaltelement (16) mittels des Ein- und Aushebegriffs (2), insbesondere mittels eines am Ein- und Aushebegriff (2) ausgebildeten Vorsprungs (9) betätigbar ist.

7. Ein- und Aushebegriff zur Verwendung in einer Ein- und Aushebevorrichtung nach einem der vorangehenden Ansprüche, **dadurch gekennzeichnet, dass** im Ein- und Aushebegriff (2) eine Führungsöffnung (8) ausgebildet ist, derart, dass der Ein- und Aushebegriff (2) sowohl um ein Führungselement drehbar als auch an diesem verschiebbar ist.

8. Ein- und Aushebegriff nach Anspruch 7, wobei die Führungsöffnung (8) länglich geformt und insbesondere als Langloch ausgebildet ist.

9. Ein- und Aushebegriff nach einem der Ansprüche 7 oder 8, **dadurch gekennzeichnet, dass** der Ein- und Aushebegriff einteilig ausgebildet ist.

10. Ein- und Aushebegriff nach einem der Ansprüche 7 bis 9, an weichem ein Vorsprung (9) ausgebildet ist, welcher Vorsprung durch eine Öffnung (15) einer Frontplatte (10) der Steckbaugruppe einführbar ist und welcher Vorsprung derart geformt ist, dass er in eingeschwenktem Zustand des Ein- und Aushebegriffs (2) durch Verschieben, insbesondere durch Verschiebung in Längsrichtung des Ein- und Aushebegriffs in der Frontplatte einklinkbar ist.

11. Steckbaugruppe umfassend mindestens eine Ein- und Aushebevorrichtung (1) nach einem der Ansprüche 1 bis 6 und/oder einen Ein- und Aushebegriff (2) nach einem der Ansprüche 7 bis 10.

12. Baugruppenträger umfassend mindestens eine Steckbaugruppe nach Anspruch 11.

## Claims

1. An insertion and extraction apparatus for the plugging in and pulling out of a plug-in module into or out of a module holder, which insertion and extraction apparatus (1) includes an insertion and extraction handle (2) and at least one guide element (3) about which the insertion and extraction handle is pivotable, **characterized in that** the insertion and extraction handle (2) can be latched by displacement in the inwardly pivoted state in a front plate 10) of the plug-in module, namely by displacement in its longitudinal direction.

2. An insertion and extraction apparatus in accordance with claim 1, wherein the guide element (3) is made as a fitted collar screw having a shoulder (3b) or as a screw with a sleeve.

3. An insertion and extraction apparatus in accordance with one of the claims 1 or 2 including a holding apparatus having at least one holding element (4) in order to hold the insertion and extraction handle (2) in a position suitable for the insertion of the plug-in module and/or to hold the insertion and extraction handle (2) in a latched in position in the inwardly pivoted state.

4. An insertion and extraction apparatus in accordance with claim 3, wherein the holding element (4) is made as a spring, in particular as a leg spring which is operatively engaged with the insertion and extraction handle (2) such that the spring is active in the direction of rotation and/or in the direction of displacement.

5. An insertion and extraction apparatus in accordance with any one of the preceding claims, wherein the holding element (4) is arranged in the region of the guide element (3), in particular at or on the guide element.

6. An insertion and extraction apparatus in accordance with any one of the preceding claims, wherein a switch element (16) for an active/passive switching of the plug-in module is provided which switch element (16) can be actuated by means of the insertion and extraction handle (2), in particular by means of a projection (9) formed at the insertion and extraction handle (2).

7. An insertion and extraction handle for use in an insertion and extraction apparatus in accordance with any one of the preceding claims, **characterized in that** a guide opening (8) is formed in the insertion and extraction handle (2) such that the insertion and extraction handle (2) is both rotatable about a guide element and displaceable thereon.

8. An insertion and extraction handle in accordance with claim 7, wherein the guide opening (8) is elongate in shape and is in particular made as an elongate hole.

9. An insertion and extraction handle in accordance with one of the claims 7 or 8, **characterized in that** the insertion and extraction handle is made in one piece.

10. An insertion and extraction handle in accordance with any one of the claims 7 to 9, at which a projection (9) is formed, which projection can be introduced through an opening (15) of a front plate (10) of the plug-in module and which projection is shaped such that it can be latched in the front plate in the inwardly pivoted state of the insertion and extraction handle (2) by displacement, in particular by displacement in the longitudinal direction of the insertion and extraction handle.

11. A plug-in module including at least one insertion and extraction apparatus (1) in accordance with any one of the claims 1 to 6 and / or an insertion and extraction handle (2) in accordance with any one of the claims 7 to 10.

12. A module holder including at least one plug-in module in accordance with claim 11.

## Revendications

1. Dispositif d'introduction et de retrait pour enficher et extraire un groupe enfichable dans ou hors d'un support, lequel dispositif d'introduction et de retrait (1) comporte un levier d'introduction et de retrait (2) et au moins un élément de guidage (3), autour duquel le levier d'introduction et de retrait peut tourner, **caractérisé en ce que** le levier d'introduction et de retrait (2) est, en plus, guidé de manière à pouvoir coulisser dans sa direction longitudinale, et **en ce que** le levier d'introduction et de retrait (2), à l'état basculé vers l'intérieur, peut être encliqueté dans une plaque frontale (10) du groupe enfichable sous l'effet d'un coulissement, à savoir un coulissement dans sa direction longitudinale.

2. Dispositif d'introduction et de retrait selon la revendication 1, dans lequel l'élément de guidage (3) est réalisé sous forme de vis de réglage avec un épaulement (3b) ou sous forme de vis à douille.

3. Dispositif d'introduction et de retrait selon la revendication 1 ou 2, comportant, en plus, un dispositif de fixation avec au moins un élément de fixation (4), pour retenir le levier d'introduction et de retrait (2) dans une position appropriée à l'enfichage du groupe enfichable et/ou pour maintenir le levier d'introduction et de retrait (2) à l'état basculé vers l'intérieur dans une position encliquetée.

4. Dispositif d'introduction et de retrait selon la revendication 3, dans lequel l'élément de fixation (4) est réalisé sous forme de ressort, en particulier sous forme de ressort à branches, qui coopère avec le levier d'introduction et de retrait (2) de telle sorte que le ressort est actif dans la direction de rotation et/ou dans la direction du coulissement.

5. Dispositif d'introduction et de retrait selon l'une quelconque des revendications précédentes, dans lequel l'élément de fixation (4) est disposé dans la zone de l'élément de guidage (3), en particulier au niveau de l'élément de guidage ou sur celui-ci.

6. Dispositif d'introduction et de retrait selon l'une quelconque des revendications précédentes, dans lequel il est prévu un élément de commande (16) pour amener le groupe enfichable dans une position active ou passive, lequel élément de commande (16) peut être actionné au moyen du levier d'introduction et de retrait (2), en particulier au moyen d'une saillie (9) réalisée sur le levier d'introduction et de retrait (2).

7. Levier d'introduction et de retrait destiné à être utilisé dans un dispositif d'introduction et de retrait selon l'une quelconque des revendications précédentes, **caractérisé en ce que** dans le levier d'introduction et de retrait (2) est réalisé un orifice de guidage (8), de telle sorte que le levier d'introduction et de retrait (2) peut tourner autour d'un élément de guidage et peut également coulisser sur celui-ci.

8. Levier d'introduction et de retrait selon la revendication 7, dans lequel l'orifice de guidage (8) est réalisé avec une forme allongée et, en particulier, sous forme de trou oblong.

9. Levier d'introduction et de retrait selon la revendication 7 ou 8, **caractérisé en ce que** le levier d'introduction et de retrait est réalisé d'un seul tenant.

10. Levier d'introduction et de retrait selon l'une quelconque des revendications 7 à 9, sur lequel est réalisée une saillie (9), qui peut être guidée à travers une ouverture (15) d'une plaque frontale (10) du groupe enfichable et qui est formée de telle sorte que, à l'état basculé vers l'intérieur du levier d'introduction et de retrait (2), elle peut être encliquetée dans la plaque frontale sous l'effet d'un coulissement, en particulier d'un coulissement dans la direction longitudinale du levier d'introduction et de retrait.

11. groupe enfichable comportant au moins un dispositif d'introduction et de retrait (1) selon l'une quelconque des revendications 1 à 6 et/ou un levier d'introduction et de retrait (2) selon l'une quelconque des revendications 7 à 10.

12. Support comportant au moins un groupe enfichable selon la revendication 11.
